# EUROPEAN PATENT SPECIFICATION

(11) **EP 3 494 243 B1**
(45) Date of publication and mention of the grant of the patent: **29.12.2021**
(21) Application number: 17749398.8
(22) Date of filing: 21.07.2017
(51) Int. Cl.: C23C 14/24, C23C 14/26, C23C 14/54

(54) **HOMOGENEOUS LINEAR EVAPORATION SOURCE WITH HEATER**
HOMOGENE LINEARE VERDAMPFUNGSQUELLE MIT HEIZER
SOURCE D'ÉVAPORATION LINÉAIRE HOMOGÈNE PRÉSENTANT UN DISPOSITIF DE CHAUFFAGE

(30) Priority: 05.08.2016 US 201662371545 P
(43) Date of publication of application: 12.06.2019
(73) Proprietor: Flisom AG, 8155 Niederhasli (CH)
(72) Inventor: PFEIFFER, Reto, 8330 Pfaeffikon (CH)
(86) International application number: PCT/EP2017/068489
(87) International publication number: WO 2018/024510

(56) References cited:
- EP-A1- 1 342 808
- JP-A- 2015 010 257
- JP-B1- 4 468 474
- US-A1- 2007 119 849
- US-A1- 2013 112 288
- US-B1- 6 444 043

## Description

### BACKGROUND

### Field

Embodiments of the present disclosure generally relate to evaporation sources used for physical vapor deposition of material onto substrates, and more particularly to an apparatus and method of depositing a material using a physical vapor deposition process on large substrates in a vacuum environment.

### Description of the Related Art

A roll-to-roll deposition process is commonly used to form CIGS (copper-indium-gallium-(di)selenide) solar cell devices. During processing, a flexible substrate is generally unwound from a roll and moved past a series of evaporation sources to deposit the different precursor elements used to form the CIGS absorber layer of the solar cell. Each evaporation source includes a crucible to heat and vaporize source material that deposits onto the flexible substrate as the substrate moves past the evaporation source. Uniform deposition of the different elements is necessary to produce a high-quality CIGS solar cell. It can be challenging to control the evaporation rate of the source material during processing, which makes it difficult to obtain a uniform deposition across the width of the substrate (e.g., the direction perpendicular to which the substrate is moving) as the substrate is moved past the evaporation source during processing. The evaporation rate of the source material is not easily measured, so it can be difficult to control the evaporation rate, especially when faced with changing conditions, such as thermal disturbances from other evaporation sources and a varying fill level of source material in the crucible during processing. It is also desirable during production to maintain a constant evaporation rate over a long duration such as several days, preferably one week. Therefore, there is a need for an evaporation source that can improve the deposition uniformity of source material. US20130112288 and US20070119849 disclose vapour deposition sources comprising heaters.

### SUMMARY

The technical problem underlying the invention is to provide an evaporation source that can provide an improved deposition uniformity for long time periods and to improve the controllability of the deposition process. Furthermore, another problem underlying the invention is to provide an evaporation source which is fast, cheap, resistant, easy to manipulate and maintain, reliable.
The object of the present invention is solved as described in the independent claims.
The dependent claims show preferred embodiments of the invention. Linear evaporation source means an evaporation source exhibiting a length considerably larger than the width of the evaporation source. The length of the evaporation source can be 3 times, preferably 7 times, more preferably 10 times or more larger than the width of the evaporation source.

Embodiments of the present disclosure generally relate to evaporation sources used for physical vapor deposition of material onto substrates, and more particularly to an apparatus and method of depositing a material using a physical vapor deposition process on large substrates in a vacuum environment.

In one embodiment, an evaporation source for depositing a source material on a substrate is provided. The evaporation source includes a crucible including a base, a plurality of walls surrounding an interior region of the crucible, the plurality of walls including a first end wall spaced apart from a second end wall in a first direction. The interior region includes a first outer region, a second outer region and a central region. The central region is disposed between the first outer region and the second outer region. Each of the first outer region, the second outer region, and the central region has a same width in the first direction. The evaporation source further includes a first heater disposed in the base, the first heater configured to provide heat at a higher rate to the first outer region than to the central region.

In another embodiment, a method of depositing a source material on a substrate is provided. The method includes placing deposition material in an interior region of a crucible. The crucible includes a base and a plurality of walls surrounding the interior region of the crucible. The plurality of walls include a first end wall spaced apart from a second end wall in a first direction. The interior region includes a first outer region, a second outer region, and a central region. The central region is disposed between the first outer region and the second outer region. Each of the first outer region, the second outer region, and the central region has a same width in the first direction. The method further includes heating the deposition material by providing more heat to the first outer region than to the central region.

In a further embodiment, an evaporation source for depositing a source material on a substrate is provided. The evaporation source includes a crucible including a base; a plurality of walls surrounding an interior region of the crucible, the plurality of walls including a first end wall spaced apart from a second end wall in a first direction. The evaporation source further includes a lid disposed over the interior region, the lid including a first outer section including a first plurality of openings, a second outer section including a second plurality of openings, and an inner section including a third plurality of openings, where the first outer section is spaced apart from the second outer section in the first direction. The inner section is disposed between the first outer section and the second outer section. The openings in the third plurality of openings are spaced farther apart from each other than the openings in the first plurality of openings are from each other.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only exemplary embodiments and are therefore not to be considered limiting of its scope, and may admit to other equally effective embodiments.
Figure 1A is a side cross-sectional view of a vapor deposition system, according to one embodiment.
Figure 1B is a side cross-sectional view of an evaporation source, according to one embodiment.
Figure 1C is a perspective view of the crucible assembly, according to one embodiment.
Figure 1D is a side cross-sectional view of a crucible, a first heater, a second heater, a lid assembly, and a substrate, according to one embodiment.
Figure 1E is a top view of the first heater, according to one embodiment.
Figure 1F is a side view of a heater, according to another embodiment.
Figure 1G is a side sectional view of a heater, according to another embodiment.
Figure 1H shows a heat output profile for the heater shown in Figure 1F, according to one embodiment.
Figure 1I shows a heat output profile for the heater shown in Figure 1G, according to one embodiment.
Figure 2A is a side cross-sectional view of an evaporation source, according to another embodiment.
Figure 2B is a side cross-sectional view of an evaporation source, according to another embodiment.
Figure 3 is a process flow diagram of a method for depositing a source material on a substrate, according to one embodiment.
Figure 4 is a side view of a heater, according to another embodiment.
Figure 5 is a top view of a heating system, according to another embodiment.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

In the following, reference is made to embodiments. However, it should be understood that the disclosure is not limited to specific described embodiments. Instead, any combination of the following features and elements, whether related to different embodiments or not, is contemplated to implement and practice the claimed subject matter. Furthermore, although embodiments described herein may achieve advantages over other possible solutions and/or over the prior art, whether or not a particular advantage is achieved by a given embodiment is not limiting of the claimed subject matter. Thus, the following aspects, features, embodiments and advantages are merely illustrative and are not considered elements or limitations of the appended claims except where explicitly recited in a claim(s).

Embodiments of the present disclosure generally relate to evaporation sources used for physical vapor deposition of material onto substrates and more particularly for controlled coating of large substrates, such as vacuum deposition of copper, indium, gallium, selenium, tellurium, cadmium, or zinc on flexible substrates. Said evaporation sources may, for example, be used within vacuum chambers where a plurality of evaporation source types, some of which may have physical and design characteristics different from the evaporation source 100 described below, are configured to implement a co-evaporation process.

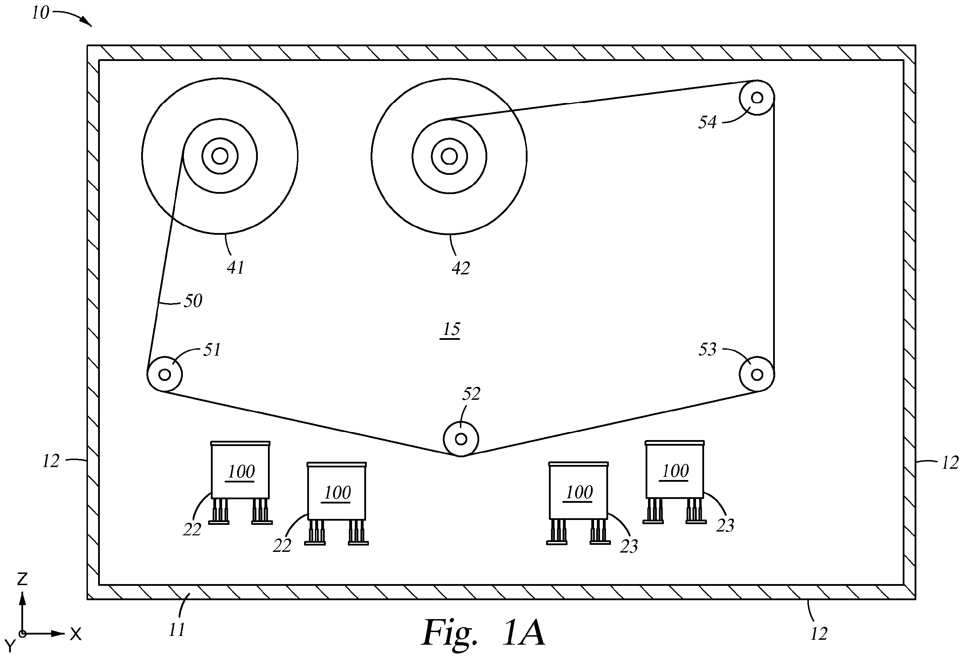

Figure 1A is a side cross-sectional view of a vapor deposition system 10, according to one embodiment. While not intending to limit the scope of the disclosure provided herein, in one embodiment, the vapor deposition system 10 is a roll-to-roll type vapor deposition system for depositing material layers onto a flexible substrate 50. The vapor deposition system 10 includes a vacuum chamber 11 including one or more walls 12 for enclosing a processing region 15 of the vapor deposition system 10. The vapor deposition system 10 can further include one or more evaporation sources 100, which are disposed within the processing region 15.

Typically, the processing region 15 of the vacuum chamber 11 is maintained at a constant vacuum pressure. The vapor deposition system 10 includes one or more sets 22, 23 of two or more evaporation sources 100 that are positioned within the processing region 15 to deposit material layer(s) onto the substrate 50 as the substrate 50 is transferred through the processing region 15. In some embodiments, the substrate 50 can include a web of flexible polyimide or flexible stainless steel material. The substrate 50 can be transferred through the processing region 15 from a feed roll 41, over tensioning rolls 51, 52, 53, 54 and to a take-up roll 42.

The evaporation sources 100 can each contain material that can be heated to a molten state, so that the heated material evaporates to coat portions of the substrate 50 as the substrate 50 passes near each evaporation source 100. The sets 22 and 23 of evaporation sources 100 may be oriented so as to follow the path of the substrate 50 through the processing region 15.

A person of ordinary skill in the art will recognize that any appropriate material may be deposited on a substrate using the vapor deposition system 10. The vapor deposition system 10 is particularly appropriate for deposition of materials to create photovoltaic cells, particularly CIGS (copper-indium-gallium-(di)selenide) solar cells or CdTe (cadmium-tellurium) solar cells. In one example, at least one CIGS-containing semiconductive photovoltaic layer, also known as the absorber layer, is deposited onto a portion of the substrate 50. The semiconductive photovoltaic layer may, for example, be made of an "ABC" material, wherein "A" represents elements in group 11 of the periodic table of chemical elements (e.g., copper (Cu) or silver (Ag)), "B" represents elements in group 13 of the periodic table (e.g., indium (In), gallium (Ga), or aluminum (Al)), and "C" represents elements in group 16 of the periodic table (e.g., sulfur (S), selenium (Se), or tellurium (Te)). An example of an ABC₂ material is the Cu(In,Ga)Se₂ semiconductor also known as a CIGS material. Other thin-film absorber materials include cadmium telluride (CdTe) and its variants, perovskites, amorphous silicon, thin-film silicon, as well as absorber materials used to manufacture dye-sensitized solar cells or organic solar cells.

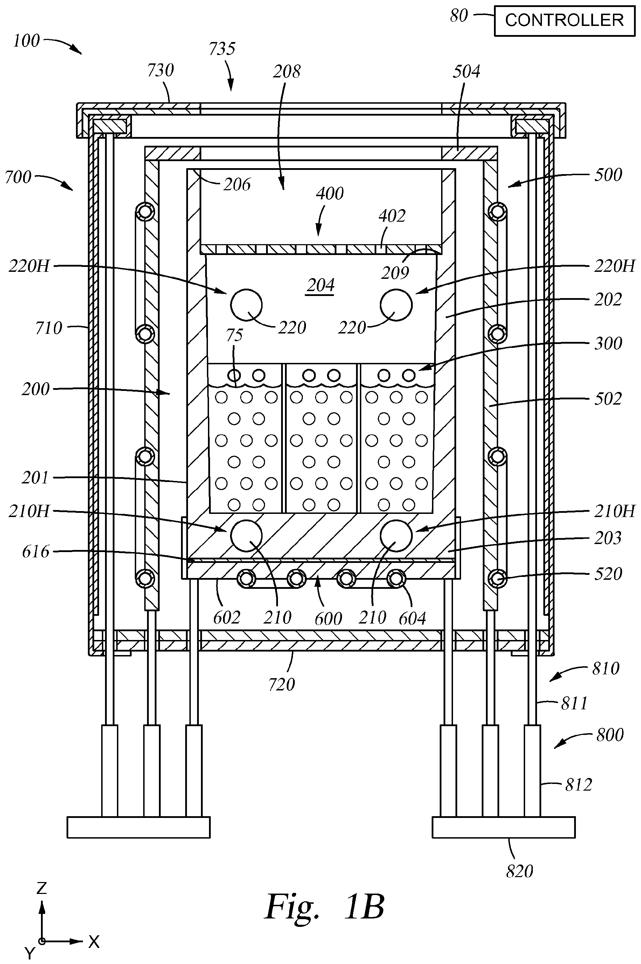

Figure 1B is a side cross-sectional view of one of the evaporation sources 100, according to one embodiment. The evaporation source 100 includes a crucible assembly 200 that includes a crucible 201 and a first heater 210H. The first heater 210H includes a heating cable 210. The crucible 201 can be formed of a material having high-thermal conductivity, such as molybdenum, graphite or stainless steel. The crucible 201 includes one or more walls 202, a base 203, and a top 206. The one or more walls 202 surround the interior region 204 of the crucible 201. The crucible 201 further includes an opening 208 above the interior region 204 of the crucible 201 and surrounded by the top 206 of the crucible 201. Deposition material 75 (e.g., a precursor element such as copper, indium, gallium, or selenium) can be placed in an interior region 204 of the crucible 201 and heated, so that vapor of the deposition material 75 can be directed through the opening 208 of the crucible 201 to deposit on the substrate 50 (see Figure 1A).

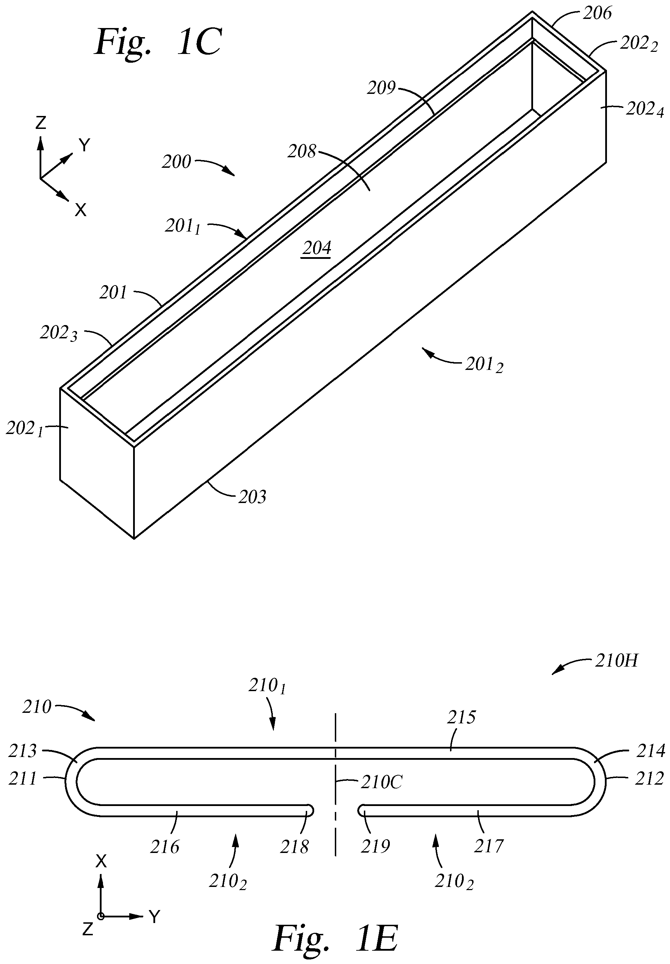

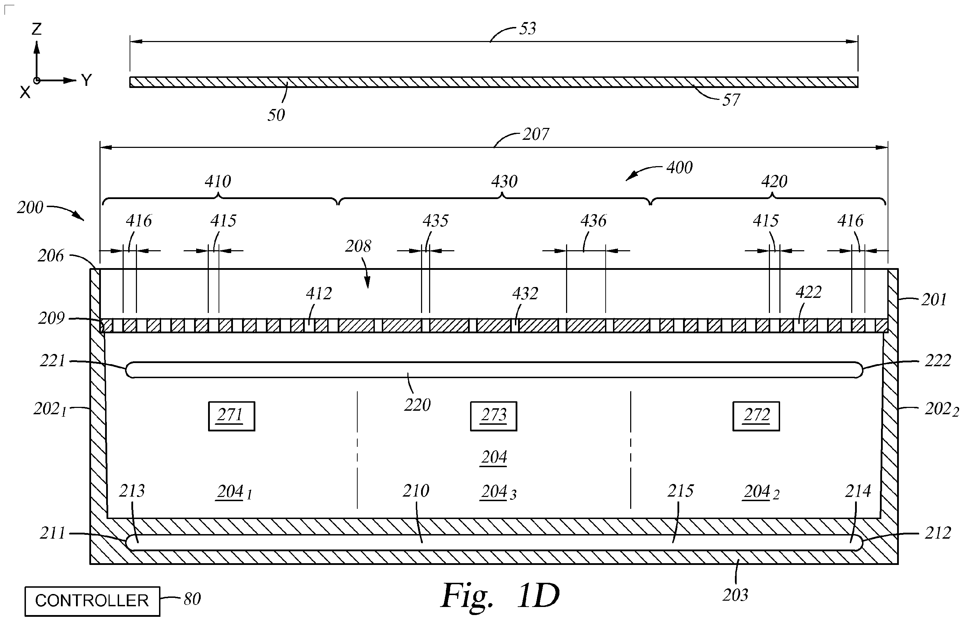

The first heater 210H provides heat to melt and evaporate the deposition material 75 (e.g., copper, indium, gallium, or selenium) in the interior region 204 of the crucible 201 during processing. In some embodiments, the first heater 210H can be disposed within the base 203 of the crucible 201 to provide heat from below the deposition material 75. In some embodiments, the first heater 210H can include a heating cable 210, such as a sheathed heating cable, powered by electrical connections (not shown). Further details of the first heater 210H are described below in reference to Figures 1C and 1D.

In some embodiments, the evaporation source 100 can further include a thermal distributor 300 disposed within the interior region 204 of the crucible 201. However, in some embodiments the thermal distributor 300 may be omitted. The thermal distributor 300 can be used to uniformly distribute heat to the deposition material 75 during processing. The thermal distributor 300 can be fabricated from a material that is heat-resistant, chemically compatible with the deposition material 75 and has a high thermal conductivity, such as refractory metals, such as molybdenum. The thermal distributor 300 can be sized in relation to interior region 204 of the crucible 201 to ensure good thermal contact between the thermal distributor 300 and the one or more walls 202 of the crucible 201.

The evaporation source 100 can further include a second heater 220H. The first heater 220H includes a corresponding heating cable 220. Although the evaporation source 100 is shown including two heaters 210H, 220H, in some embodiments only one heater may be included. The second heater 220H can be disposed in the interior region 204 of the crucible 201 above the thermal distributor 300. In some embodiments, the deposition material 75 can be maintained at levels below the top of the thermal distributor 300, which keeps the second heater 220H in a position that contacts vapor of deposition material 75, but the not the liquid deposition material 75. The second heater 220H can be used to provide heat to the deposition material 75 and to control the evaporation rate of the deposition material 75. In some embodiments, the second heater 220H can include a heating cable 220, such as a sheathed heating cable, powered by electrical connections (not shown).

In some embodiments, the first heater 210H can be used to control the temperature of the liquid deposition material 75 and the second heater 220H can be used to control the temperature of the vapor of the deposition material 75. For example, a first temperature control loop (e.g., PID loop) can be executed by a controller 80, where a first temperature sensor (not shown) configured to sense the temperature of deposition material 75 is the input to the first temperature control loop and the power provided to the first heater 210H is the output of the first temperature control loop. Similarly, a second temperature control loop (e.g., PID loop) can be executed by the controller 80, where a second temperature sensor (not shown) configured to sense the temperature of the vapor of the deposition material 75 is the input to the second temperature control loop and the power provided to the second heater 220H is the output of the second temperature control loop. In other embodiments, both heaters 210H, 220H can be used to control the temperature of the deposition material 75. Further details of the second heater 220H are described below in reference to Figures 1D and 1E. However, in some embodiments the first heater 210H and/or the second heater 220H may be omitted.

The evaporation source 100 further includes a lid assembly 400 disposed above the thermal distributor 300. The lid assembly 400 can be positioned on a supporting ridge 209 of the crucible 201. The lid assembly 400 thermally isolates the interior region 204 of the crucible 201 from the areas above the crucible 201. The lid assembly 400 may be formed from a heat resistant and thermally conductive material, such as molybdenum or graphite. The lid assembly 400 includes openings 402 to direct evaporated deposition material towards the substrate 50 (see Figure 1A) during processing. In one configuration, the openings 402 are sized to control the effusion of material from the evaporation source 100. In one example, the diameters of the openings 402 are from about 1 millimeter (mm) to about 40 mm, such as from about 2 mm to about 20 mm in size, and are spaced apart from each other by a distance from about 5 mm to about 400 mm, such as from about 10 mm to about 200 mm. Furthermore, in some embodiments, one or more of the openings 402 can have a shape of a slot having a length from about 20 mm to about 80 mm, such as about 40 mm.

The evaporation source 100 further includes a thermal isolation assembly 500 disposed around the crucible 201. The thermal isolation assembly 500 includes one or more vertical walls 502 and a top plate 504. The one or more vertical walls 502 can surround the one or more walls 202 of the crucible 201. The top plate 504 can be disposed over the top 206 of the crucible 201. The thermal isolation assembly 500 isolates the walls and top of the crucible 201 from variations in thermal loads coming from outside of the thermal isolation assembly 500, such as heat coming from one of the other evaporation sources 100 in the vacuum chamber 11. For example, without the thermal isolation assembly 500, the crucible assembly 200 would receive heat from other sources in the vacuum chamber 11, such as other evaporation sources 100. In some embodiments, the one or more of the walls 502 can be formed of a material having high thermal conductivity, such as copper. The thermal isolation assembly 500 can further include one or more cooling tubes 520. The cooling tubes 520 can be disposed around and/or adjacent to the one or more walls 502. Cooling fluid may be distributed through the cooling tube(s) 520 to prevent external sources of heat from causing thermal disturbances within the interior region 204 of the crucible 201.

In some embodiments, the evaporation source 100 can further include a cooling assembly 600. However, in some embodiments, the cooling assembly 600 may be omitted. The cooling assembly 600 includes a cooling plate 602 disposed below the crucible 201. The cooling plate 602 can be used too rapidly cool the deposition material 75 when processing is completed or stopped. The cooling assembly 600 may further include one or more cooling tubes 604. In some embodiments, a sheet 616 material having a high thermal conductivity, such as graphite, may be disposed between the cooling plate 602 and the crucible 201 to further promote thermal contact between the cooling plate 601 and the crucible 201. The sheet 616 may also help provide some temperature regulation, control of the crucible 201 temperature and reduced stress in the cooling plate 601 and crucible 201 due to a difference in temperature between the cooling plate 601 and the crucible 201 during processing.

The evaporation source 100 further includes a heat shield assembly 700 disposed around the thermal isolation assembly 500 and the cooling assembly 600 to further prevent external heat loads from causing thermal disturbances within the interior region 204 of the crucible 201. The heat shield assembly 700 includes one or more side wall portions 710, one or more base portions 720, and a lid portion 730. The one or more materials used for the side wall portions 710 can be chosen to be chemically compatible with the material evaporated by the evaporation source 100, and such materials can include stainless steel and molybdenum as these materials pose a low risk of contaminating the evaporation process. The one or more base portions 720 can be disposed below the cooling assembly 600. The lid portion 730 can be disposed above the top plate 504 of the thermal isolation assembly 500. The lid portion 730 may be supported by the one or more side wall portions 710. Each portion 710, 720, 730 can be formed of a highly reflective and heat-resistant material, such as molybdenum. In some embodiments, each portion 710, 720, 730 can include two or more sheets of the highly reflective, heat-resistant material, such as molybdenum.

The evaporation source 100 further includes a leg assembly 800. The leg assembly 800 provides support for other assemblies within the evaporation source 100, such as the thermal isolation assembly 500, the cooling assembly 600, and the heat shield assembly 700. Adjustment and positioning of the leg assembly 800 also determines where the evaporation source 100 is positioned within the vacuum chamber 11 (Figure 1A). In some embodiments, the feet 820 of the leg assembly 800 are positioned on a portion of the wall 12 of the vapor deposition system 10. In one configuration, the leg assembly 800 includes a plurality of legs 810 and a plurality of feet 820 that are used to level and vertically position the evaporation source 100 relative to the substrate 50 and thermally isolate the evaporation source 100 from portions of the vapor deposition system 10.

Figure 1C is a perspective view of the crucible assembly 200, according to one embodiment. In some embodiments, the crucible 201 can have a shape substantially similar to a rectangular prism having an open top. An evaporation source 100 having a crucible with a substantially rectangular shape, such as the crucible 201, is referred to herein as a linear evaporation source. The substrate 50 (Figure 1A) can be moved linearly above the linear evaporation source including the crucible 201 in the X-direction.

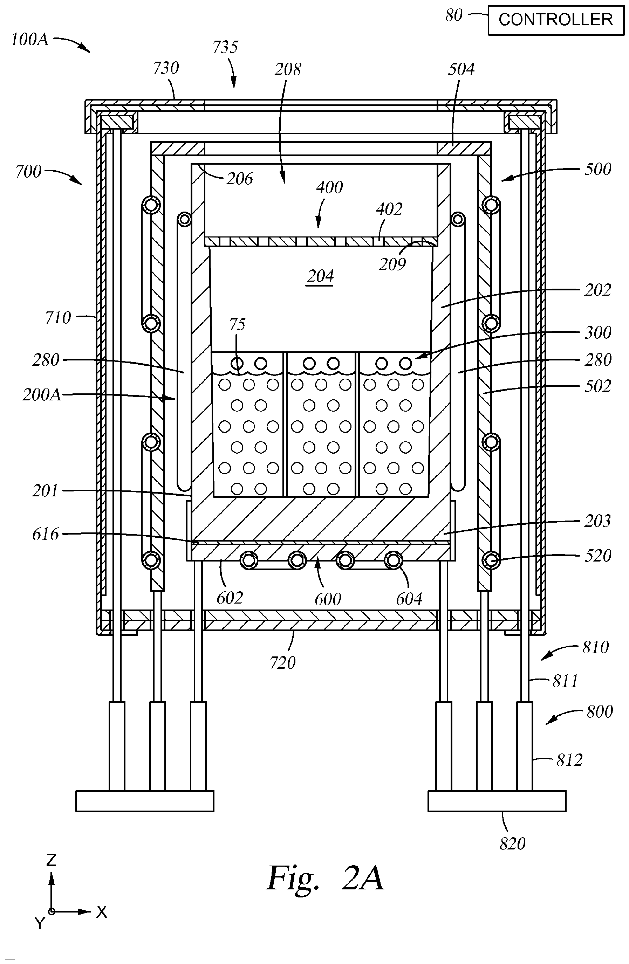

In embodiments including a linear evaporation source such as the crucible 201, the walls 202 can include a first end wall 202₁, a second end wall 202₂ opposite to the first end wall 202₁, a first side wall 202₃, and a second side wall 202₄ opposite to the first side wall 202₃. The first side wall 202₃ connects the first end wall 202₁ to the second end wall 202₂ along a first side 201₁ of the crucible 201. The second side wall 202₄ connects the first end wall 202₁ to the second end wall 202₂ along a second side 201₂ of the crucible 201. The side walls 202₃, 202₄ each have a horizontal length (Y-direction in Figure 2A) extending in a direction from the first end wall 202₁ to the second end wall 202₂. The end walls 202₁, 202₂ each have a horizontal length (X-direction in Figure 1C) extending in a direction from the first side wall 202₃ to the second side wall 202₄.

The side walls 202₃, 202₄ generally have a horizontal length that is longer than the length of the end walls 202₁, 202₂. The substrate 50 (Figure 1A) moves above the crucible 201 in the X-direction and the width of the substrate 50 in the Y-direction can be disposed over most of opening 208 of the crucible 201 in the Y-direction, such as 60% or more of the opening 208 in the Y-direction. In some embodiments, a ratio of the length of the side walls 202₃, 202₄ in the Y-direction to the length of the end walls 202₁, 202₂ in the X-direction can be from about 5:1 to about 500:1. In some embodiments, the length of the side walls 202₃, 202₄ in the Y-direction is related to the width of the substrate 50 in the Y-direction. For example, the length of the side walls 202₃, 202₄ in the Y-direction may be longer than the width of the substrate 50 in the Y-direction by about 20 mm to about 400 mm, such as by about 200 mm. In some embodiments, the length of the side walls 202₃, 202₄ in the Y-direction may be longer than the width of the substrate 50 in the Y-direction by a first distance (FD) that is related to the distance (i.e., second distance (SD)) between the opening 208 of the crucible 201 to the substrate 50 in the Z-direction. In one example, the first distance (FD) has a magnitude that is between the second distance divided by five (SD/5) and about five times the second distance (5 × SD).

Figure 1D is a side cross-sectional view of the crucible 201, the first heater 210H, the second heater 220H, the lid assembly 400, and the substrate 50, according to one embodiment. The view in Figure 1D shows a cross-section of the Y-Z plane, which is perpendicular to the movement of the substrate 50 in the X-direction as shown in Figure 1A.

The opening 208 of the crucible 201 has a width 207 (Figure 1D) in the Y-direction that is greater than a width 55 of the substrate 50. Vapor from the deposition material 75 (Figure 1A) can be directed towards a lower surface 57 of the substrate 50 through all or substantially all of the width 207 of the opening 208 of the crucible 201. Having the width 207 of the opening 208 be wider than the width 55 of the substrate 50 can help to ensure the lower surface 57 of the substrate 50 is fully and homogeneously coated by the vapor of the deposition material 75. The heating cable 210 of the first heater 210H can extend in the Y-direction from a first end 211 to a second end 212 for a length that is substantially as long as the width 207 of the opening 208, such as a length that is at least 75% of the width 207, such as a length that is at least 90% of the width 207. The heating cable 220 of the second heater 220H can extend in the Y-direction from a first end 221 to a second end 222 for a length that is substantially as long as the width 207 of the opening 208, such as a length that is at least 75% of the width 207, such as a length that is at least 90% of the width 207.

The lid assembly 400 can include a first outer section 410, a second outer section 420, and an inner section 430. The first outer section 410 can be disposed on the supporting ridge 209 of the crucible 201 at or proximate to the first end wall 202₁. The second outer section 420 can be disposed on the supporting ridge 209 of the crucible 201 at or proximate to the second end wall 202₂. The inner section 430 can be disposed between the first outer section 410 and the second outer section 420. The inner section 430 can be substantially centered in the crucible 201 in the Y-direction.

Although the openings of the lid assembly 400 are collectively referred to as openings 402 (Figure 1B), the lid assembly 400 can include different groups of openings. The first outer section 410 can include a first plurality of openings 412 that are spaced apart from each other in the Y-direction by a first distance 416. The second outer section 420 can include a second plurality of openings 422 that are also spaced apart from each other in the Y-direction by the first distance 416. The inner section 430 can include a third plurality of openings 432 that are spaced apart from each other in the Y-direction by a second distance 436. The second distance 436 can be greater than the first distance 416, which can allow for a greater concentration of openings in the outer sections 410, 420 than in the inner section 430. The greater concentration of openings in the outer sections 410, 420 can help to increase the flux of vapor of the deposition material 75 (Figure 1B) towards the substrate 50 through the openings in the outer sections 410, 420 relative to outer sections (not shown) that include the same concentration of openings as the inner section 430. The increased heat loss can slow the flux of vapor of deposition material 75 at outer sections that include the same concentration of openings as the inner section 430. Thus, the increased flux of vapor through the outer sections 410, 420 having a greater concentration of openings 412, 422 than the openings 432 in the inner section 430 can help reduce the variability of the deposition rate on the lower surface 57 of the substrate 50 in the Y-direction.

Furthermore, in some embodiments the openings in the first plurality of openings 412 and the second plurality of openings 422 in the outer sections 410, 420 can have a width 415 (e.g., a diameter) in the Y-direction that is greater than a width 435 (e.g., a diameter) in the Y-direction of the third plurality of openings 432 in the inner section 430. The increased width 415 of the openings 412, 422 relative to the width 435 of the openings 432 is another way to increase the flux of vapor of the deposition material 75 towards the substrate 50 through the openings in the outer sections 410, 420, which serves as a another way of reducing the variability of the deposition rate on the lower surface 57 of the substrate 50 in the Y-direction.

In other embodiments, the lid assembly 400 can include a plurality of openings that are spaced apart from each other in the Y-direction by distances that vary, such as increase or decrease (e.g., between each pair of openings), based on how far the openings are from a center of the lid assembly in the Y-direction. For example, the openings that are closest to the center of the lid assembly in the Y-direction could be spaced apart from each other by the greatest distance, and the openings that are closest to either one of the crucible walls, such as the first end wall 202₁ could be spaced apart from each other by the shortest distance. Similarly, in some embodiments the width of the openings could increase for each opening based on how far the openings are from a center of the lid assembly in the Y-direction. For example, the openings located closest to the center of the lid assembly in the Y-direction could have the narrowest width in the Y-direction, and the openings located closest to either one of the crucible end walls 202₁, 202₂, could have the widest width in the Y-direction. By increasing the spacing between each pair of the openings or by increasing the width of the openings for each opening as distance is increased from the center of the lid assembly in the Y-direction in a more continuous manner, the variability of the deposition rate on the lower surface 57 of the substrate 50 in the Y-direction can be further reduced.

The interior 204 of the crucible 201 can include a first outer region 204₁, a second outer region 204₂, and a central region 204₃. The central region 204₃ can be disposed between the first outer region 204₁ and the second outer region 204₂. Each region 204₁, 204₂, 204₃ can extend for a same distance in the Y-direction. Each region 204₁, 204₂, 204₃ can include a respective temperature sensor 271, 272, 273 (Figure 1D) to measure the temperature in the respective region 204₁, 204₂, 204₃. In some embodiments, each temperature sensor 271, 272, 273 can be placed at a height in the Z-direction so that the temperature sensor is always within the molten deposition material 75 (see Figure 1B). In other embodiments one or more of the temperature sensors 271, 272, 273 can be placed at a height in the Z-direction to measure a temperature of the vapor of the deposition material 75 (e.g., within region 204 (Figure 1B)).

Figure 1E is a top view of the first heater 210H (e.g., looking -Z-direction), according to one embodiment. Although Figure 1E is described in reference to the first heater 210H, the second heater 220H can have a similar shape and have similarities to other features of the first heater 210H described in Figure 1E.

As described above, the heating cable 210 of the first heater 210H extends from the first end 211 to the second end 212 in the Y-direction. The first heater 210H includes a first curved portion 213 located at the first end 211. The first heater 210H includes a second curved portion 214 located at the second end 212. The first heater 210H has a first side 210₁ spaced apart from a second side 210₂ in the X-direction. The heating cable 210 includes a first segment 215 extending along the first side 210₁ of the first heater 210H and connecting the first curved portion 213 to the second curved portion 214. The view of the first heater 210H in Figure 1D is a side view of the first segment 215 extending from the first curved portion 213 to the second curved portion 214. Furthermore, the similar view of the second heater 220H in Figure 1D can be a side view of a corresponding first segment extending between corresponding curved portions on the second heater 220H.

The heating cable 210 further includes a first inner segment 216 extending along the second side 210₂ of the first heater 210H from the first curved portion 213 towards a center 210C of the first heater 210H in the Y-direction. The heating cable 210 further includes a second inner segment 217 extending along the second side 210₂ from the second curved portion 214 towards the center 210C of the first heater in the Y-direction. The heating cable 210 can further include a first inner end 218 and a second inner end 219 spaced apart from each other in the Y-direction. The first inner segment 216 can be connected to the first inner end 218. The second inner segment 217 can be connected to the second inner end 219. Electrical current can flow through the heating cable 210 of the first heater 210H from the first inner end 218, through the first inner segment 216, through the first curved portion 213, through the first segment 215, through the second curved portion 214, through the second inner segment 217, and to the second inner end 219. The overall shape of the first heater 210H can be an open loop with the spacing between the first inner end 218 and the second inner end 219 representing the opening in the loop. Electrical connections (not shown) can be made to the first inner end 218 and the second inner end 219 to provide power to the first heater 210H.

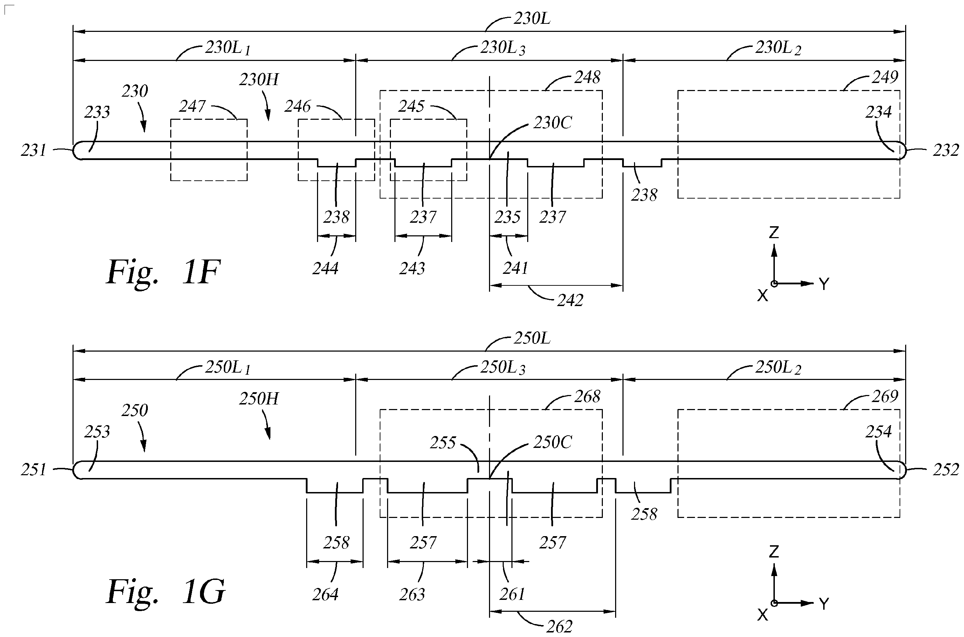

Figure 1F is a side view of a heater 230H, according to one embodiment. The heater 230H can be used, for example, in place of the first heater 210H (see Figure 1D) in some embodiments and is referred to in the following description as the first heater 230H. The top view (not shown) of the first heater 230H can be the same as the top view of the first heater 210H shown in Figure 1E. The view of the first heater 230H shown in Figure 1F can correspond to the side view shown in Figure 1D of the first heater 210H. The first heater 230H can include a heating cable 230 including a first segment 235 extending from a first curved portion 233 located at a first end 231 of the heating cable 230 to a second curved portion 234 located at a second end 232 of the heating cable 230. Because the top view (not shown) of the first heater 230H can be the same as the top view of the first heater 210H shown in Figure 1E, the first heater 230H can also include portions (not shown) corresponding to the first inner segment 216 and the second inner segment 217 shown in Figure 1E.

The first heater 230H is similar to the first heater 210H described above except that the first heater 230H includes one or more portions having a varying power output per unit length. In one configuration, the first heater 230H is similar to the first heater 210H described above except that the first heater 230H includes one or more portions having an increased thickness, so that the amount of heat emitted by the first heater 230H (e.g., power = I²R = V²/R) can vary in the Y-direction (i.e., the direction that corresponds to the width 55 of the substrate disposed above the crucible 201 as shown in Figure 1D) as a current is delivered through, and/or voltage is applied across, the length of the first heater 230H. Although the increased thickness can be in more than one direction or all directions (e.g., a rounded cable having an increased thickness), the increased thickness is shown here for the first heater 230H in the Z-direction. The first heater 230H has a center 230C in the Y-direction. The heating cable 230 of the first heater 230H can include two first portions 237 having an increased thickness relative to the remainder of the first segment 235 that is not part of a portion having an increased thickness, such as the portion of first segment 235 shown in region 247. Each first portion 237 having an increased thickness can be spaced apart from the center 230C in the Y-direction by a first distance 241, wherein the first portions 237 are disposed on opposing sides of the center 230C from each other in the Y-direction. Each first portion 237 has an increased thickness that can extend for a first length 243 in the Y-direction.

The heating cable 230 of the first heater 230H can further include two second portions 238 having an increased thickness relative to the remainder of the first segment 235 that is not part of a portion having an increased thickness, such as the portion of first segment 235 shown in region 247. Each second portion 238 having an increased thickness can be spaced apart from the center 230C in the Y-direction by a second distance 242, wherein the second portions 238 are disposed on opposing sides of the center 230C from each other in the Y-direction. Each second portion 238 has an increased thickness that extends for a second length 244 in the Y-direction.

The portions 237, 238 having increased thickness are used to alter the amount of heat emitted along the lengths 243, 244 of the portions 237, 238 relative to corresponding lengths in the first segment 235 not having an increased thickness, such as the portion of first segment 235 shown in region 247. The increased thickness of the portions 237, 238 lowers the electrical impedance of the portions 237, 238 across the respective lengths 243, 244 relative to the electrical impedance of corresponding lengths of the first segment 235 not having an increased thickness. Thus, the portions 237, 238 emit less heat than portions of the first segment 235 having the same length in the Y-direction but not having an increased thickness.

The first distance 241 is less than the second distance 242, so the first portions 237 are located closer to the center 230C than the second portions 238 are to the center 230C. Furthermore, the first length 243 is longer than the second length 244, so the first portions 237 extend for a longer length in the Y-direction than the second portions 238 extend in the Y-direction. The locations of the first portions 237, which are closer to the center 230C, and the longer lengths of the first portions 237 relative to the second portions 238, causes the first heater 230H to emit less heat to regions that are closer to the center 230C than to similarly sized regions that are further from the center 230C. Furthermore, the first heater 230H emits more heat to regions not including a portion having an increased thickness. For example, for three regions of the same size including a first region 245 surrounding one of the first portions 237, a second region 246 surrounding one of the second portions 238, and a third region 247 surrounding a portion of the first segment 235 not having an increased cross-sectional area, the least amount of heat is emitted to the first region 245, the most amount of heat is emitted to the third region 247, and the heat emitted to the second region 246 is greater than the first region 245 but less than the third region 247.

Thus, in some embodiments, the amount of heat provided by the first heater 230H generally increases in the Y-direction as the heating cable 230 extends away from the center 230C. Referring to Figure 1D, by providing more heat from portions of the first heater 230H that are further away from the center 230C, more heat can be provided to the outer regions 204₁, 204₂ of the interior region 204 of the crucible 201, such as regions of the interior region 204 of the crucible 201 near or bordering the first end wall 202₁ and the second end wall 202₂. By providing more heat to the outer regions of the interior region 204 of the crucible 201, the variability in the evaporation rate of the deposition material 75 (see Figure 1B) in the Y-direction can be reduced. For example, if a constant rate of heat is provided in the Y-direction, then the evaporation rate of the deposition material 75 (see Figure 1B) can be lower at the outer regions of the interior region 204 of the crucible 201 due to the increased heat losses around these outer regions. Thus, by providing additional heat to these outer regions using the first heater 230H accounts for the additional heat loss at the outer regions, and the variability in the evaporation rate of the deposition material 75 (see Figure 1B) in the Y-direction can be reduced.

Figure 1G is a side sectional view of a heater 250H, according to one embodiment. The heater 250H can be used, for example, in place of the second heater 220H (see Figure 1D) in some embodiments and is referred to in the following description as the second heater 250H. The view of the heater 250H shown in Figure 1F can correspond to the view shown in Figure 1D of the second heater 220H. The top view (not shown) of the heater 250H can be the same as the top view of the first heater 210H shown in Figure 1E. The heater 250H can include a heating cable 250 including a first segment 255 extending from a first curved portion 253 located at a first end 251 of the second heater 250H to a second curved portion 254 located at a second end 252 of the second heater 250H. Because the top view (not shown) of the second heater 250H can be the same as the top view of the first heater 210H shown in Figure 1E, the second heater 250H can also include portions (not shown) corresponding to the first inner segment 216 and the second inner segment 217 shown in Figure 1E.

The second heater 250H can be the same as the first heater 230H except that the heater 250H can include portions having larger increased thicknesses than the portions 237, 238 of the first heater 230H. For example, in the second heater 250H the first portions 237 from the first heater 230H are replaced with larger first portions 257. These larger first portions 257 extend for a first distance 263 in the Y-direction that is longer than the first length 243 that the first portions 237 extended for in the Y-direction. Furthermore, these larger first portions 257 can extend further in the Z-direction than the first portions 237. Similarly, in the second heater 250H the second portions 238 from the first heater 230H are replaced with larger second portions 258. These larger second portions 258 extend for a second distance 264 in the Y-direction that is longer than the second length 244 that the second portions 238 extended for in the Y-direction. Furthermore, these larger second portions 258 can extend further in the Z-direction than the second portions 238.

Furthermore, the portions 257, 258 are located closer a center 250C of the second heater 250H in the Y-direction than the portions 237, 238 are to the center 230C of the first heater 230H described above. For example, the first portions 257 are located a first distance 261 from the center 250C, which is less than the first distance 241 of the first portions 237 to the center 230C of the first heater 230H described above. The second portions 258 are located a second distance 262 from the center 250C, which is less than the second distance 242 of the second portions 238 to the center 230C of the first heater 230H described above.

By making the portions 257, 258 of the heater 250H larger than the respective portions 237, 238 of the first heater 230H, and by positioning the portions 257, 258 closer to the center 250C of the second heater 250H than the respective portions 237, 238 are to the center 230C of the first heater 230H, the heater second 250H provides less heat to a central region surrounding the center of the second heater 250H than a central region of the same size surrounding the first heater 230H when both heaters 230H, 250H are supplied with the same power. For example, Figure 1F shows a central region 248 surrounding both of the first portions 237 of the first heater 230H, and Figure 1G shows a central region 268 surrounding both of the first portions 257 of the second heater 250H, where the central region 248 and the central region 268 are the same size. The larger size and closer location to the center 250C of the first portions 257 causes the second heater 250H to provide less heat to the central region 268 than the first heater 230H provides to the central region 248, which has the same size as the central region 268 when the heaters 230H, 250H are supplied with the same power.

Furthermore, there is a larger difference in heat provided between central regions relative to outer regions in the second heater 250H than there is for a difference in heat provided between central regions relative to outer regions for the first heater 230H when both heaters 230H, 250H are supplied with the same power. For example, Figure 1F shows an outer region 249 surrounding an outer portion of the first heater 230H. The outer region 249 can be the same size as the central region 248. Figure 1G shows an outer region 269 surrounding an outer portion of the second heater 250H. The outer region 269 can be the same size as the central region 268 in Figure 1G and can also be the same size as the regions 248, 249 in Figure 1F. Furthermore, the portion of the first heater 230H surrounded by the region 249 can be identical to the portion of the second heater 250H surrounded by the region 269. Because the second heater 250H includes larger first portions 257 than the first portions 237 of the first heater 230H and because the portions of the heaters 230H, 250H surrounded by the respective regions 249, 269 can be identical, the reduced heat provided to the central region 268 by the second heater 250H relative to the heat provided to the central region 248 by the first heater 230H causes the difference in heat provided to the central region 268 relative to the outer region 269 to be larger than the difference in heat provided to the central region 248 relative to the outer region 249. Thus, the second heater 250H can be described as providing a steeper heating profile in the Y-direction than the first heater 230H due to the larger changes in heat provided in the Y-direction for the second heater 250H than the changes in heat provided by the first heater 230H in the Y-direction.

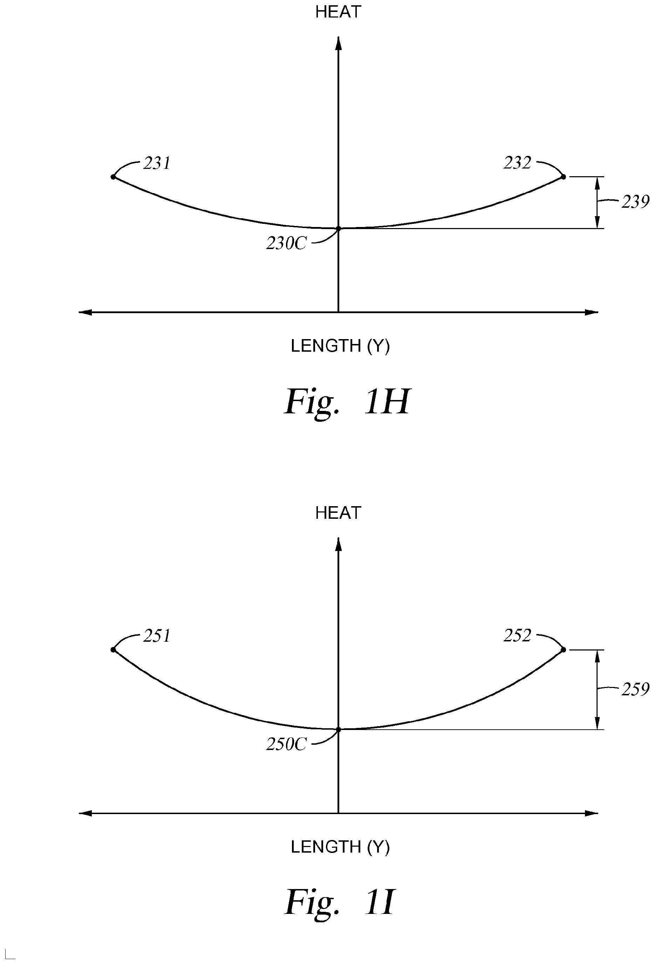

For example, the difference between the heating profiles of the first heater 230H and the second heater 250H are shown in Figures 1H and 1I. Figure 1H shows a heat output profile for the first heater 230H, according to one embodiment. Similarly, Figure 1I shows a heat output profile for the second heater 250H, according to one embodiment. The first heater 230H generates more at the ends 231, 232 than at the center 230C, and the additional heat produced at the ends 231, 232 relative to the center 230C can be represented by a first difference 239. The first heater 250H generates more at the ends 251, 252 than at the center 250C, and the additional heat produced at the ends 251, 252 relative to the center 250C can be represented by a second difference 259. The second difference 259 is greater than the first difference 239, and thus the second heater 250H has a steeper heating profile than the first heater 230H.

By having two heaters 230H, 250H that each provide a varying amount of heat in the Y-direction while also having one of the heaters 250H provide a steeper heating profile, the two heaters 230H, 250H can be used together to reduce the variability of the temperature of the deposition material 75 (see Figure 1B) and vapor of the deposition material 75 in the Y-direction. For example, if temperatures of the deposition material 75 are higher in central region 204₃ of the interior region 204 of the crucible 201 (see Figure 1D) than outer regions 204₁, 204₂ of the interior region 204 of the crucible 201, then power provided to the second heater 250H can be increased because the steeper heating profile of the second heater 250H causes increases in power to the second heater 250H to have a greater effect on heating outer regions 204₁, 204₂ (see Figure 1D) of the interior region 204 of the crucible 201 than central regions 204₃ of the interior region 204 of the crucible 201. Similarly, reducing the power provided to the first heater 230H would have a greater effect on reducing the temperature of central region 204₃ of the interior region 204 of the crucible 201 than outer regions 204₁, 204₂ of the interior region 204 the crucible 201. On the other hand, if the temperatures of the deposition material 75 are higher in outer regions 204₁, 204₂ of the interior region 204 of the crucible 201 than central region 204₃ of the interior region 204 of the crucible 201, then opposite actions can be taken with the power provided to the heaters 230H, 250H to reduce the variability of the temperature of the deposition material 75 in the Y-direction (e.g., reducing the power provided to the second heater 250H, or increasing the power provided to the first heater 230H).

Referring to Figures 1D, 1F and 1G, the varying amount of heat that the heaters 230H, 250H can provide can be explained relative to having regions that deliver varying amounts of power, such as by use of the larger sections of the heater. Because the exact positon of the portions having increased thicknesses (e.g., portions 237, 238) can be adjusted, an explanation relative to larger sections of the heaters 230H, 250H can be applicable to a wider set of the embodiments contemplated by the disclosure provided herein. The heaters 230H, 250H can each have a respective length 230L, 250L extending in the Y-direction. Each length 230L, 250L can be divided into thirds of equal length including a respective first outer section 230L₁, 250L₁, and a respective second outer section 230L₂, 250L₂, and a respective inner section 230L₃, 250L₃. For each heater 230H, 250H, more heat can be generated by the first outer section 230L₁, 250L₁ or the second outer section 230L₂, 250L₂ than is generated by the inner section 230L₃, 250L₃. Furthermore, for each heater 230H, 250H, the heat generated by the first outer section 230L₁, 250L₁, can be substantially equal to the heat generated by the second outer section 230L₂, 250L₂.

Although the heaters 230H, 250H are largely described as having two sets of portions having increased thicknesses (i.e., portions 237, 238 for the first heater 230H and portions 257, 258 for the second heater 250H) relative to the remainder of the heaters 230H, 250H, other embodiments may include more or less portions having varying power output (e.g., increased thicknesses) or have different designs for varying the amount of heat provided in the Y-direction. For example, in one embodiment the cross-sectional area of the heating cable of a heater can continuously decrease in the Y-direction from the center of the heating cable in the Y-direction. Furthermore, although the portions 237, 238 of the first heater 230H (see Figure 1F) and the portions 257, 258 of the second heater 250H (see Figure 1G) are described as extending from respective first segments 235, 255, which are similar to the first segment 215 shown in Figure 1E, the heaters 230H, 250H can also include corresponding portions 237, 238, 257, 258 extending from the segments of the heaters 230H, 250H corresponding to the inner segments 216, 217 shown in Figure 1E, so that the heaters 230H, 250H provide an amount of heat that is balanced in the X-direction.

In some embodiments, each heater 230H, 250H can be replaced by two heaters, so that a temperature variability of the deposition material 75 in the interior region 204 of the crucible 201 that is not symmetrical about a center in the Y-direction of the interior region 204 of the crucible 201 can be controlled. For example, referring to Figure 1D it is possible that there may be greater heat loss on the left side of the crucible 201 than there is for on the right side of the crucible 201. Thus, the heaters 230H, 250H (see Figure 1F, 1G) having the open loop design (see Figure 1E) could each be replaced by, for example, two heaters having an open loop design that does not extend as far in the Y-direction, so that the two heaters may be placed side-by-side in the X-Y plane at the locations in the Z-direction for each of the heaters 210H, 220H shown in Figure 1B.

Figure 2A is a side cross-sectional view of an evaporation source 100A, according to one embodiment. The evaporation source 100A is similar to the evaporation source 100 described above (see Figure 1B) except that the evaporation source 100A includes a crucible assembly 200A that is different from the crucible assembly 200 described above, and the evaporation source 100A also does not include the second heater 220H described above. The crucible assembly 200A includes a heater 280 disposed around the walls 202 of the crucible 201. The heater 280 can include a heating cable, such as a sheathed heating cable. The heating cable can be distributed across each of the walls 202 in a pattern using a plurality of loops. A portion of two of these loops is visible in Figure 2A. The loops allow thermal expansion of the heating cable of the heater 280 with respect to the crucible 201. Electric power may be applied to the heating cable of the heater 280 to provide the heat to the crucible 201 by a power supply that is coupled to a temperature control system. By using the heater 282 direct heat through the crucible walls 202, the variability in the temperature of the deposition material 75 in the X-direction and the Y-direction can be reduced. This is because the additional heat losses that occur around the perimeter of the crucible 201 can be substantially negated by providing the heat through the perimeter of the crucible 201. In another embodiment, the heater 280 may be placed in the crucible walls 202 to place the heater 280 closer to the material being heated. In yet another embodiment, the heater 280 may surround the crucible 201, a heater similar to the heater 280 may be placed below the crucible 201, and an additional heater, such as the heater 220H (See Figure 1B) or heater 250H (Figure 1G) may disposed in the interior region 204 of the crucible 201 above the thermal distributor 300.

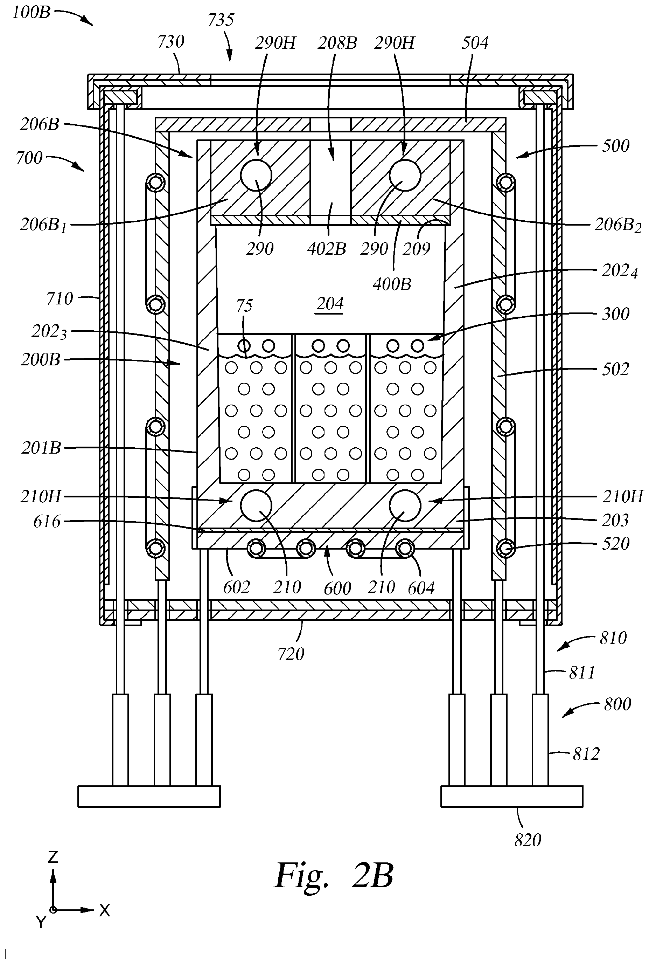

Figure 2B is a side cross-sectional view of an evaporation source 100B, according to one embodiment. The evaporation source 100B is similar to the evaporation source 100 described above (see Figure 1B) except that the evaporation source 100B includes a crucible assembly 200B that is different from the crucible assembly 200 described above, the evaporation source 100B also does not include the second heater 220H described above, and the evaporation source 100 B includes a lid assembly 400B that is different from the lid assembly 400 described above. The lid assembly 400B includes openings 402B disposed in a central location in the X-direction. The openings 402B can be wider in the X-direction than the openings 402 (see Figure 1B) described above. The openings 402B can be distributed in the Y-direction using a pattern similar to the distribution of the openings 402 shown in Figure 1D. For example, the openings 402B can be narrower at the center in the Y-direction of the lid assembly 400B than openings 402B at outer regions of the lid assembly 400B, and the openings 402B can be spaced further apart at the center of the lid assembly 400B in the Y-direction than openings 402B at outer regions of the lid assembly 400B.

The crucible assembly 200B includes a crucible 201B that is different from the crucible 201 described above. The crucible 201B includes a top 206B extending over the interior region 204 of the crucible 201B. The top 206B includes a first portion 206B₁ extending from the first side wall 202₃ and a second portion 206B₂ extending from the second side wall 202₄. The crucible assembly 200B can further include a heater 290H including a corresponding cable 290 disposed in the top 206B of the crucible 201B. Although the crucible assembly 200B is shown including two heaters 210H, 290H, in some embodiments only one heater may be included. A top view of the heater 290H can have the same shape as the top view of the first heater 210H shown in Figure 1E. The top 206B can also include portions (not shown) extending in from the walls 202₁, 202₂ to house the curved portions of the heater 290H, which can have a similar shape to the curved portions 213, 214 of the first heater 210H. By disposing the heater 290H in the top 206B of the crucible 201B, temperature variations in the interior of the crucible 201B above the thermal distributor 300 can be reduced. For example, the high thermal mass of the top 206B of the crucible 201B can prevent small changes in the power provided to the heater 290H from causing large changes to the temperature of the vapor of the deposition material 75 because the high thermal mass of the top 206B allows the heat released into the interior region 204 by the top 206B to respond slowly to changes in heat provided to the top 206B. The heaters 210H, 290H can also be replaced with the heaters 230H, 250H described above in reference to Figures 1F, 1G, so that temperature variations in the Y-direction can be reduced as described above. Furthermore, in some embodiments, either the first heater 210H or the heater 290H may be omitted.

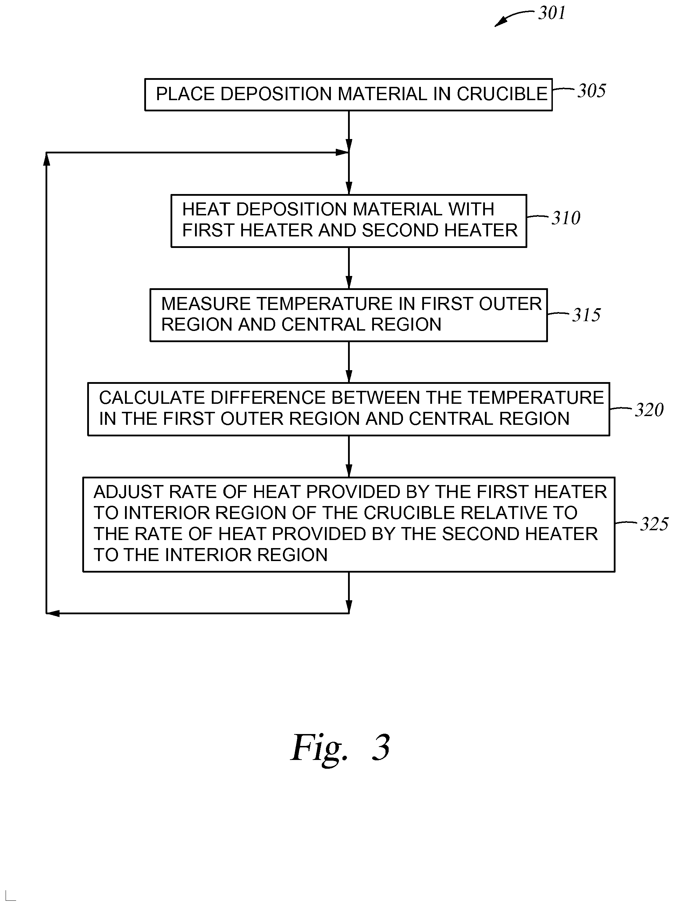

Figure 3 is a process flow diagram of a method 301 for depositing a source material on a substrate, according to one embodiment. Referring to Figures 1B, 1D, 1F, and 1G, the method 301 is described. The method 301 can be performed using the evaporation source 100 to deposit vapor of the deposition material 75 (see Figure 1B) on the substrate 50 (see Figure 1D). The heaters 230H, 250H are used in place of the heaters 210H, 220H in the evaporation source 100.

At block 305, deposition material 75 is placed in the interior region 204 of the crucible 201. At block 310, the heaters 230H, 250H heat the deposition material 75. As described above, in order to reduce the variability of the temperature of the deposition material 75 in the Y-direction, the heaters 230H, 250H provide heat at a higher rate to the first outer region 204₁ (see Figure 1D) than to the central region 204₃ as well as heat at a higher rate to the second outer region 204₂ than to the central region 204₃.

Furthermore, the second heater 250H provides a greater proportion of its heat to the outer regions 204₁, 204₂ than the proportion the first heater 230H provides to the outer regions 204₁, 204₂. For example, if (1) the heat transfer rate provided by the first heater 230H to the first outer region 204₁ relative to the heat transfer rate provided by the first heater 230H to the central region 204₃ can be expressed as a first ratio, and (2) the heat transfer rate provided by the second heater 250H to the first outer region 204₁ relative to the heat transfer rate provided by the second heater 250H to the central region 204₃ can be expressed as a second ratio, then the second ratio is greater than the first ratio.

At block 315, a first temperature is measured in the first outer region 204₁ using the temperature sensor 271 (Figure 1D) and a second temperature is measured in the central region 204₃ using the temperature sensor 273 (Figure 1D). In some embodiments, a third temperature can also be measured in the second outer region 204₂. At block 320, a difference between the first temperature and the second temperature can be calculated, for example by the controller 80 (Figure 1D).

At block 325, a rate of heat provided by the first heater 230H to the interior region 204 relative to a rate of heat provided by the second heater 250H to the interior region 204 is adjusted, for example by the controller 80, based on the difference between the first temperature and the second temperature. Although the following describes adjusting the rates of heat based on temperature measurements, in some embodiments the rates of heat may be adjusted based on measurements of evaporation rates or measurements of thicknesses on different portions of the substrate 50. For example, if the second temperature is greater than the first temperature, then (1) the rate of heat provided by the second heater 250H to the interior region 204 can be increased relative to the rate of heat provided by the first heater 230H to the interior region 204, or (2) the rate of heat provided by the first heater 230H to the interior region 204 can be decreased relative to the rate of heat provided by the second heater 250H to the interior region 204. In one embodiment, the controller 80 (Figure 1D) can calculate a difference between a temperature setpoint for the interior region 204 and an average of the first temperature and the second temperature to determine whether to increase the rate of heat provided by the second heater 250H or to decrease the rate of heat provided by the first heater 230H when the second temperature is greater than the first temperature. For example, if second temperature is greater than the first temperature, the temperature setpoint is 900°C, and the average of the first temperature and the second temperature is 899.5°C, then the controller 80 can adjust an output from the controller to increase the rate of heat provided by the second heater 250H, so that the overall temperature of the interior region 204 increases and the difference between the first temperature and the second temperature is reduced. After adjusting the rate of heat provided by the heaters 230H, 250H at block 325, the method 301 can continue cycling through blocks 310 through 325 to maintain a low level of variability of the temperature in the interior region 204 in the Y-direction.

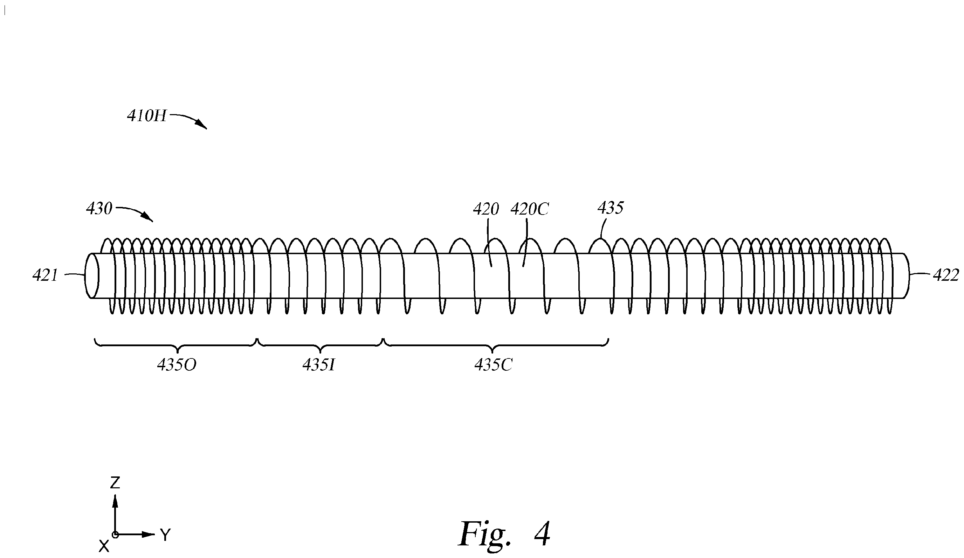

Figure 4 is a side view of a heater 410H, according to one embodiment. The heater 410H can be used, for example, in place of one or more of the heaters 210H, 220H, and 290H described above. In some embodiments, the heater 410H can have a shape of the heater 210H as shown in Figure 1E. The heater 410H includes a core 420. The core extends from a first end 421 to a second end 422. The core further includes a center 420C. In some embodiments, the core 420 may be formed of a heat resistant electrically insulating material (e.g., ceramic, or in some embodiments a graphitic material with an insulating and heat resistant coating). The heater 410H may further include a heating cable 430, which can be wrapped around the core 420. For example, in some embodiments, the heating cable 430 can be wrapped around the core 420 in a helical pattern to form a series of rings 435 extending substantially from the first end 421 to the second 422 of the core 420. The heating cable 430 can be disposed within slots or cavities formed within a surface of the core 420 in a helical pattern that extends along the length of the core 420.

The spacing between the rings 435 can vary from the first end 421 to the center 420C and from the center 420C to the second end 422. For example, the rings 435 can include an outer section 435O at the first end 421, a central section 435C at the center 420C, and an intermediate section 435I located between the outer section 435O and the central section 435C. The cable can also include corresponding intermediate and outer sections on the right side of the center 420C. The rings 435 in the central section 435C can be spaced apart further from each other than the rings 435 in the intermediate section 435I are spaced apart from each other, and the rings 435 in the intermediate section 435I can be spaced apart further from each other than the rings 435 in the outer section 435O are spaced apart from each other. Sections of the heater 410H having closely packed rings 435 can produce more heat than sections of the heater 410H having loosely packed rings 435. Thus, the outer region 435O having the most closely packed rings 435 can produce more heat along a given length in the Y-direction than the heat produced by the intermediate section 435I or the central region 435C along the same length in the Y-direction. Furthermore, the central region 435C having the most loosely packed rings 435 produces less heat than the heat produced by the intermediate region 435I or the outer region 435O. The spacing between the rings 435 can be varied as needed along the length of the core 420 to produce the desired heating profile in the Y-direction. Furthermore, in embodiments including two or more heaters (e.g., the evaporation source 100 of Figure 1B) the spacing between the rings 435 in the different heaters can vary according to different profiles in the Y-direction, so that the two heaters can be used together to independently reduce the variability of the temperature of the deposition material 75 (see Figure 1B) in the Y-direction and the temperature of the vapor of the deposition material 75 in the Y-direction.

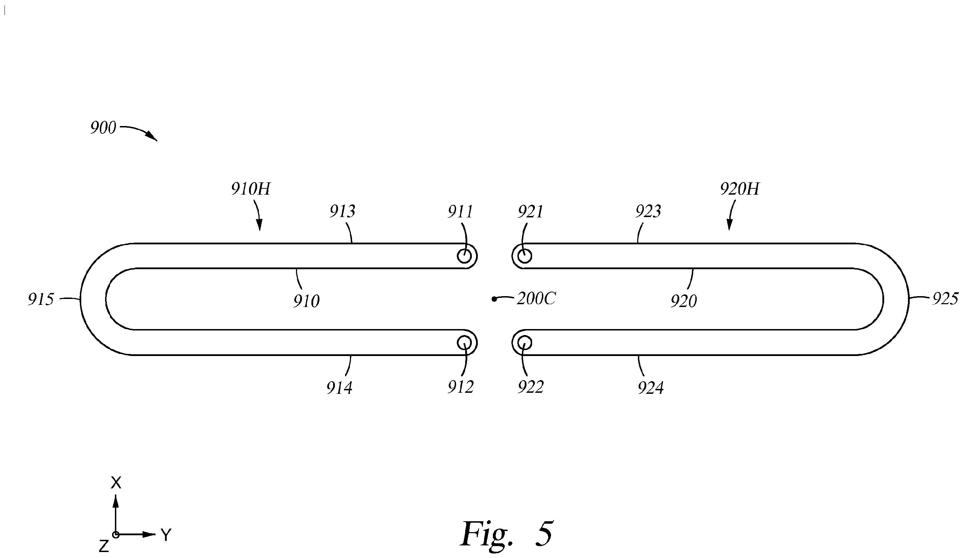

Figure 5 is a top view of a heating system 900, according to one embodiment. The heating system 900 can be used, for example, in place of one or more of the heaters 210H, 220H, 290H, and 410H described above. The heating system 900 includes a first heater 910H and a second heater 920H. The first heater 910H and the second heater 920H can be spaced apart from each other in the Y-direction to enable independent heating of areas of the evaporation source (e.g., evaporation source 100 described above) that are spaced apart in the Y-direction. For example, in some embodiments the heaters 910H, 920H can be symmetrically positioned around a center 200C of the crucible assembly (e.g., crucible assembly 200 described above). Independent heating of different portions of the crucible assembly spaced apart in the Y-direction can be useful when the heat loss at opposing ends of the crucible assembly differ from each other.

The first heater 910H includes a first heating cable 910 having a first leg 911 and a second leg 912. The first leg 911 extends from a first inner end 913 to a curved portion 915. The second leg 912 extends from a second inner end 914 to the curved portion 915. The curved portion 915 connects the first leg 911 to the second leg 912. The curved portion 915 can be disposed in the Y-direction in a corresponding position to the curved portion 213 described above in reference to the heater 210H of Figure 1E.

The second heater 920H includes a second heating cable 920 having a first leg 921 and a second leg 922. The first leg 921 extends from a first inner end 923 to a curved portion 925. The second leg 922 extends from a second inner end 924 to the curved portion 925. The curved portion 925 connects the first leg 921 to the second leg 922. The curved portion 925 can be disposed in the Y-direction in a corresponding position to the curved portion 214 described above in reference to the heater 210H of Figure 1E.

While the foregoing is directed to embodiments of the present disclosure, other and further embodiments of the disclosure may be devised without departing from the basic scope thereof, and the scope thereof is determined by the claims that follow.

## Claims

1. A linear evaporation source (100) suited for the production of CIGS thin films for depositing a metal or semi-metal source material (75) on a substrate (50), the evaporation source (100) comprising:
a crucible (201) comprising:
a base (203);
a plurality of walls (202) surrounding an interior region (204) of the crucible (201), the plurality of walls including a first end wall (202₁) spaced apart from a second end wall (202₂) in a first direction (Y), wherein
the interior region (204) includes a first outer region (204₁), a second outer region (204₂) and a central region (204₃),
the central region (204₃) disposed between the first outer region (204₁) and the second outer region (204₂); and
each of the first outer region (204₁), the second outer region (204₂), and the central region (204₃) has a same width in the first direction (Y); and
a first heater (230H) disposed in the base (203), the first heater (230H) configured to provide heat at a higher rate to the first outer region (204₁) than to the central region (204₃),
whereby said first heater (230H) is configured as a heating cable substantially parallel to the longitudinal axis of said linear evaporation source (100).

2. The evaporation source (100) of claim 1, further comprising a second heater (250H) disposed above the base (203), the second heater (250H) configured to provide heat at a higher rate to the first outer region (204₁) than to the central region (204₃).

3. The evaporation source (100) of claim 2, wherein
a first ratio defines the rate at which the first heater (230H) is configured to heat the first outer region (204₁) relative to the rate at which the first heater (230H) is configured to heat the central region (204₃);
a second ratio defines the rate at which the second heater (250H) is configured to heat the first outer region (204₁) relative to the rate at which the second heater (250H) is configured to heat the central region (204₃); and
the second ratio is higher than the first ratio.

4. The evaporation source (100) of claim 2 or 3, further comprising a lid (400) disposed over the base (203), wherein the second heater (250H) is disposed between the base (203) of the crucible (201) and the lid (400).

5. The evaporation source (100B) of claim 2 or 3 or 4, wherein the second heater (290H) is disposed in a top (206B) of the crucible (201B).

6. The evaporation source (100) according to any of the preceding claims, wherein the first heater (230H) is formed of a first cable (230) having a thickness that varies in the first direction (Y).

7. The evaporation source (100) according to any of the preceding claims 2-6, wherein the second heater (250H) is formed of a first cable (250) having a thickness that varies in the first direction (Y).

8. The evaporation source (100) according to any of the preceding claims, further comprising a lid (400) disposed over the interior region (204), the lid comprising a first outer section (410) including a first plurality of openings (412), a second outer section (420) including a second plurality of openings (422), and an inner section (430) including a third plurality of openings (432), wherein
the first outer section (410) is spaced apart from the second outer section (420) in the first direction (Y);
the inner section (430) is disposed between the first outer section (410) and the second outer section (420); and
the openings (432) in the third plurality of openings (432) are spaced farther apart from each other than the openings (412) in the first plurality of openings (412) are from each other.

9. The evaporation source (100) of claim 8, wherein the openings (432) in the third plurality of openings (432) are spaced further apart from each other than the openings (422) in the second plurality of openings (422) are from each other.

10. A method of depositing a metal or semi-metal source material (75) on a substrate (50), the method comprising:
placing deposition material (75) in an interior region (204) of a crucible (201) of a linear evaporation source (100) , the crucible (201) comprising:
a base (203);
a plurality of walls (202) surrounding the interior region (204) of the crucible (201), the plurality of walls including a first end wall (202₁) spaced apart from a second end wall (202₂) in a first direction (Y), wherein
the interior region (204) includes a first outer region (204₁), a second outer region (204₂) and a central region (204₃),
the central region (204₃) disposed between the first outer region (204₁) and the second outer region (204₂); and
each of the first outer region (204₁), the second outer region (204₂), and the central region (204₃) has a same width in the first direction (Y); and
heating the deposition material (75) by providing more heat to the first outer region (204₁) than to the central region (204₃ ) via at least a first heater (230H) configured as a heating cable substantially parallel to the longitudinal axis of said linear evaporation source (100).

11. The method of claim 10, wherein heating the deposition material (75) comprises:
heating the deposition material (75) with a first heater (230H) disposed below the interior region (204), wherein
the first heater (230H) is configured to provide heat at a higher rate to the first outer region (204₁) than to the central region (204₃); and
a rate of heat provided by the first heater (230H) to the first outer region (204₁) relative a rate of heat provided by the first heater (230H) to the central region (204₃) is a first ratio.

12. The method of claim 10 or 11, wherein heating the deposition material (75) comprises:
heating the deposition material (75) with a second heater (250H) disposed above the deposition material (75), wherein
the second heater (250H) is configured to provide heat at a higher rate to the first outer region (204₁) than to the central region (204₃); and
a rate of heat provided by the second heater (250H) to the first outer region (204₁) relative a rate of heat provided by the second heater (250H) to the central region (204₃) is a second ratio.

13. The method of claim 12 used for the production of CIGS thin films, wherein the second ratio is different than the first ratio.

14. The method of claim 13, further comprising
measuring a first temperature in the first outer region (204₁);
measuring a second temperature in the central region (204₃);
calculating a difference between the first temperature and the second temperature; and
adjusting a rate of heat provided by the first heater (230H) to the interior region (204) relative to a rate of heat provided by the second heater (250H) to the interior region (204) based on the difference between the first temperature and the second temperature.

15. The method of claim 12 or 13 or 14 used for the production of CIGS thin films, wherein the second ratio is greater than the first ratio.

16. The method of claim 15, further comprising
measuring a first temperature in the first outer region (204₁);
measuring a second temperature in the central region (204₃), wherein the second temperature is greater than the first temperature;
calculating a difference between the first temperature and the second temperature; and
increasing a rate of heat provided by the second heater (250H) to the interior region (204) relative to a rate of heat provided by the first heater (230H) to the interior region (204) based on the difference between the first temperature and the second temperature.

## Patentansprüche

1. Lineare Verdampfungsquelle (100), die zum Abscheiden eines Metall- oder Halbmetallquellenmaterials (75) auf einem Substrat (50) für die Herstellung von CIGS-Dünnschichten geeignet ist, wobei die Verdampfungsquelle (100) umfasst:
einen Tiegel (201), umfassend:
eine Basis (203);
eine Vielzahl von Wänden (202), die einen Innenbereich (204) des Tiegels (201) umgeben, wobei die Vielzahl von Wänden eine erste Endwand (202₁) umfasst, die von einer zweiten Endwand (202₂) in einer ersten Richtung (Y) beabstandet ist, wobei
der Innenbereich (204) einen ersten Außenbereich (204₁), einen zweiten Außenbereich (204₂) und einen zentralen Bereich (204₃) umfasst,
wobei der zentrale Bereich (204₃) zwischen dem ersten äußeren Bereich (204₁) und dem zweiten äußeren Bereich (204₂) angeordnet ist; und
jeder des ersten äußeren Bereichs (204₁), des zweiten äußeren Bereichs (204₂) und des zentralen Bereichs (2043) eine gleiche Breite in der ersten Richtung (Y) hat; und
eine erste Heizung (230H), die in der Basis (203) angeordnet ist, wobei die erste Heizung (230H) konfiguriert ist, um dem ersten äußeren Bereich (204₁) Wärme mit einer höheren Rate als dem zentralen Bereich (204₃) bereitzustellen,
wobei die erste Heizeinrichtung (230H) als ein Heizkabel konfiguriert ist, das im Wesentlichen parallel zur Längsachse der linearen Verdampfungsquelle (100) verläuft.

2. Verdampfungsquelle (100) nach Anspruch 1, ferner umfassend eine zweite Heizung (250H), die über der Basis (203) angeordnet ist, wobei die zweite Heizung (250H) konfiguriert ist, um Wärme mit einer höheren Rate an den ersten äußeren Bereich (204₁) als dem zentralen Bereich (204₃) bereitzustellen.

3. Verdampfungsquelle (100) nach Anspruch 2, wobei
ein erstes Verhältnis die Rate definiert, mit der die erste Heizung (230H) konfiguriert ist, um den ersten äußeren Bereich (204₁) relativ zu der Rate, mit der die erste Heizung (230H) konfiguriert ist, um den zentralen Bereich (2043) zu erwärmen;
ein zweites Verhältnis die Rate definiert, mit der die zweite Heizung (250H) konfiguriert ist, um den ersten äußeren Bereich (204₁) relativ zu der Rate, mit der die zweite Heizung (250H) konfiguriert ist, um den zentralen Bereich (2043) zu heizen; und
das zweite Verhältnis höher ist als das erste Verhältnis.

4. Verdampfungsquelle (100) nach Anspruch 2 oder 3, ferner umfassend einen Deckel (400), der über der Basis (203) angeordnet ist, wobei die zweite Heizeinrichtung (250H) zwischen der Basis (203) des Tiegels (201) und der Deckel (400) angeordnet ist.

5. Verdampfungsquelle (100B) nach Anspruch 2 oder 3 oder 4, wobei die zweite Heizeinrichtung (290H) in einem Oberteil (206B) des Tiegels (201B) angeordnet ist.

6. Verdampfungsquelle (100) nach einem der vorhergehenden Ansprüche, wobei die erste Heizeinrichtung (230H) aus einem ersten Kabel (230) gebildet ist, dessen Dicke in der ersten Richtung (Y) variiert.

7. Verdampfungsquelle (100) nach einem der vorhergehenden Ansprüche 2 bis 6, wobei die zweite Heizeinrichtung (250H) aus einem ersten Kabel (250) gebildet ist, dessen Dicke in der ersten Richtung (Y) variiert.

8. Verdampfungsquelle (100) nach einem der vorhergehenden Ansprüche, ferner umfassend einen Deckel (400), der über dem Innenbereich (204) angeordnet ist, wobei der Deckel einen ersten äußeren Abschnitt (410) mit einer ersten Vielzahl von Öffnungen (412), einen zweiten äußeren Abschnitt (420) mit einer zweiten Vielzahl von Öffnungen (422) und einen inneren Abschnitt (430) mit einer dritten Vielzahl von Öffnungen (432) umfasst, wobei
der erste äußere Abschnitt (410) vom zweiten äußeren Abschnitt (420) in der ersten Richtung (Y) beabstandet ist;
der innere Abschnitt (430) zwischen dem ersten äußeren Abschnitt (410) und dem zweiten äußeren Abschnitt (420) angeordnet ist; und
die Öffnungen (432) in der dritten Vielzahl von Öffnungen (432) weiter voneinander beabstandet sind als die Öffnungen (412) in der ersten Vielzahl von Öffnungen (412) voneinander beabstandet sind.

9. Verdampfungsquelle (100) nach Anspruch 8, wobei die Öffnungen (432) in der dritten Vielzahl von Öffnungen (432) weiter voneinander beabstandet sind als die Öffnungen (422) in der zweiten Vielzahl von Öffnungen (422) voneinander beabstandet sind.

10. Verfahren zum Abscheiden eines Metall- oder Halbmetallquellenmaterials (75) auf einem Substrat (50), wobei das Verfahren umfasst:
Platzieren von Abscheidungsmaterial (75) in einem Innenbereich (204) eines Tiegels (201) einer linearen Verdampfungsquelle (100), wobei der Tiegel (201) umfasst:
eine Basis (203);
eine Vielzahl von Wänden (202), die den Innenbereich (204) des Tiegels (201) umgeben, wobei die Vielzahl von Wänden eine erste Endwand (202₁) umfasst, die von einer zweiten Endwand (2022) in einer ersten Richtung (Y) beabstandet ist, wobei
der Innenbereich (204) einen ersten Außenbereich (2041), einen zweiten Außenbereich (204₂) und einen zentralen Bereich (204₃) umfasst,
wobei der zentrale Bereich (204₃) zwischen dem ersten äußeren Bereich (204₁) und dem zweiten äußeren Bereich (204₂) angeordnet ist; und
jeder von dem ersten äußeren Bereich (2041), dem zweiten äußeren Bereich (204₂) und dem zentralen Bereich (204₃) hat eine gleiche Breite in der ersten Richtung (Y); und
Erhitzen des Abscheidungsmaterials (75), indem dem ersten äußeren Bereich (204₁) mehr Wärme zugeführt wird als dem zentralen Bereich (204₃) über mindestens eine erste Heizeinrichtung (230H), die als Heizkabel im Wesentlichen parallel zur Längsachse der linearen Verdunstungsquelle (100) verläuft.

11. Verfahren nach Anspruch 10, wobei das Erwärmen des Abscheidungsmaterials (75) umfasst:
Erwärmen des Abscheidungsmaterials (75) mit einer ersten Heizeinrichtung (230H), die unter dem Innenbereich (204) angeordnet ist, wobei
die erste Heizeinrichtung (230H) konfiguriert ist, um Wärme mit einer höheren Rate an den ersten äußeren Bereich (2041) als an den zentralen Bereich (2043) bereitzustellen; und
eine Wärmerate, die von der ersten Heizung (230H) an den ersten äußeren Bereich (204₁) geliefert wird, relativ zu einer Wärmerate, die von der ersten Heizung (230H) an die zentrale Region (2043) geliefert wird, ein erstes Verhältnis ist.

12. Verfahren nach Anspruch 10 oder 11, wobei das Erwärmen des Abscheidungsmaterials (75) umfasst:
Erhitzen des Abscheidungsmaterials (75) mit einem zweiten Heizgerät (250H), das über dem Abscheidungsmaterial (75) angeordnet ist, wobei
die zweite Heizeinrichtung (250H) konfiguriert ist, um Wärme mit einer höheren Rate an den ersten äußeren Bereich (204₁) als an den zentralen Bereich (204₃) bereitzustellen; und
eine Wärmerate, die von der zweiten Heizung (250H) an den ersten äußeren Bereich (204₁) geliefert wird, relativ zu einer Wärmerate, die von der zweiten Heizung (250H) an die zentrale Region (204₃) geliefert wird, ein zweites Verhältnis ist.

13. Verfahren nach Anspruch 12, das zur Herstellung von CIGS-Dünnschichten verwendet wird, wobei das zweite Verhältnis von dem ersten Verhältnis verschieden ist.

14. Verfahren nach Anspruch 13, ferner umfassend:
Messen einer ersten Temperatur im ersten äußeren Bereich (204₁);
Messen einer zweiten Temperatur im zentralen Bereich (204₃);
Berechnen einer Differenz zwischen der ersten Temperatur und der zweiten Temperatur; und
Einstellen einer Wärmerate, die von der ersten Heizung (230H) an den Innenbereich (204) geliefert wird, relativ zu einer Wärmerate, die von der zweiten Heizung (250H) an den Innenbereich(204) geliefert wird, basierend auf der Differenz zwischen der ersten Temperatur und der zweiten Temperatur.

15. Verfahren nach Anspruch 12 oder 13 oder 14, das zur Herstellung von CIGS-Dünnschichten verwendet wird, wobei das zweite Verhältnis größer als das erste Verhältnis ist.

16. Verfahren nach Anspruch 15, ferner umfassend:
Messen einer ersten Temperatur im ersten äußeren Bereich (204₁);
Messen einer zweiten Temperatur im zentralen Bereich (204₃), wobei die zweite Temperatur höher als die erste Temperatur ist;
Berechnen einer Differenz zwischen der ersten Temperatur und der zweiten Temperatur; und
Erhöhen einer Wärmerate, die von der zweiten Heizung (250H) an den Innenbereich (204) geliefert wird, relativ zu einer Wärmerate, die von der ersten Heizung (230H) an den Innenbereich (204) geliefert wird, basierend auf der Differenz zwischen der ersten Temperatur und der zweiten Temperatur.

## Revendications

1. Source d'évaporation linéaire (100) adaptée à la réalisation de couches minces CIGS pour le dépôt d'un matériau source métallique ou semi-métallique (75) sur un substrat (50), la source d'évaporation (100) comprenant :
un creuset (201) comprenant :
un socle (203) ;
une pluralité de parois (202) entourant une région intérieure (204) du creuset (201), la pluralité de parois comprenant une première paroi d'extrémité (202₁) espacée d'une seconde paroi d'extrémité (202₂) dans une première direction (Y), dans lequel
la région intérieure (204) comprend une première région extérieure (204₁), une deuxième région extérieure (204₂) et une région centrale (204₃),
la région centrale (204₃) disposée entre la première région extérieure (204₁) et la deuxième région extérieure (204₂); et
chacune de la première région extérieure (204₁), de la deuxième région extérieure (204₂) et de la région centrale (204₃) a une même largeur dans la première direction (Y) ; et
un premier élément chauffant (230H) disposé dans la base (203), le premier élément chauffant (230H) étant configuré pour fournir de la chaleur à un débit plus élevé à la première région extérieure (204₁) qu'à la région centrale (204₃),
dans lequel ledit premier élément chauffant (230H) est configuré comme un câble chauffant sensiblement parallèle à l'axe longitudinal de ladite source d'évaporation linéaire (100).

2. Source d'évaporation (100) selon la revendication 1, comprenant en outre un deuxième élément chauffant (250H) disposé au-dessus de la base (203), le deuxième élément chauffant (250H) configuré pour fournir de la chaleur à un débit plus élevé à la première région externe (204₁) qu'à la région centrale (2043).

3. Source d'évaporation (100) selon la revendication 2, dans laquelle
un premier rapport définit la vitesse à laquelle le premier élément chauffant (230H) est configuré pour chauffer la première région extérieure (204₁) par rapport à la vitesse à laquelle le premier élément chauffant (230H) est configuré pour chauffer la région centrale (204₃) ;
un deuxième rapport définit la vitesse à laquelle le deuxième élément chauffant (250H) est configuré pour chauffer la première région externe (204₁) par rapport à la vitesse à laquelle le deuxième élément chauffant (250H) est configuré pour chauffer la région centrale (2043) ; et
le deuxième rapport est supérieur au premier rapport.

4. Source d'évaporation (100) selon la revendication 2 ou 3, comprenant en outre un couvercle (400) disposé sur la base (203), dans laquelle le deuxième élément chauffant (250H) est disposé entre la base (203) du creuset (201) et le couvercle (400).

5. Source d'évaporation (100B) selon la revendication 2 ou 3 ou 4, dans laquelle le deuxième élément chauffant (290H) est disposé dans un sommet (206B) du creuset (201B).

6. Source d'évaporation (100) selon l'une quelconque des revendications précédentes, dans laquelle le premier élément chauffant (230H) est formé d'un premier câble (230) ayant une épaisseur qui varie dans la première direction (Y).

7. Source d'évaporation (100) selon l'une quelconque des revendications précédentes 2 à 6, dans laquelle le deuxième élément chauffant (250H) est formé d'un premier câble (250) ayant une épaisseur qui varie dans la première direction (Y).

8. Source d'évaporation (100) selon l'une quelconque des revendications précédentes, comprenant en outre un couvercle (400) disposé sur la région intérieure (204), le couvercle comprenant une première section extérieure (410) comprenant une première pluralité d'ouvertures (412), une deuxième section externe (420) comprenant une deuxième pluralité d'ouvertures (422) et une section interne (430) comprenant une troisième pluralité d'ouvertures (432), dans lequel
la première section externe (410) est espacée de la deuxième section externe (420) dans la première direction (Y) ;
la section interne (430) est disposée entre la première section externe (410) et la deuxième section externe (420) ; et
les ouvertures (432) dans la troisième pluralité d'ouvertures (432) sont plus espacées les unes des autres que les ouvertures (412) dans la première pluralité d'ouvertures (412) ne le sont les unes par rapport aux autres.

9. Source d'évaporation (100) selon la revendication 8, dans laquelle les ouvertures (432) dans la troisième pluralité d'ouvertures (432) sont plus espacées les unes des autres que les ouvertures (422) dans la deuxième pluralité d'ouvertures (422) sont de chacun d'eux.

10. Procédé de dépôt d'un matériau source métallique ou semi-métal (75) sur un substrat (50), le procédé comprenant :
placer un matériau de dépôt (75) dans une région intérieure (204) d'un creuset (201) d'une source d'évaporation linéaire (100), le creuset (201) comprenant :
un socle (203);
une pluralité de parois (202) entourant la région intérieure (204) du creuset (201), la pluralité de parois comprenant une première paroi d'extrémité (202₁) espacée d'une seconde paroi d'extrémité (2022) dans une première direction (Y), dans lequel
la région intérieure (204) comprend une première région extérieure (204₁), une deuxième région extérieure (2042) et une région centrale (2043),
la région centrale (204₃) disposée entre la première région extérieure (204₁) et la deuxième région extérieure (204₂); et
chacune de la première région extérieure (204₁), de la deuxième région extérieure (204₂) et de la région centrale (204₃) a une même largeur dans la première direction (Y) ; et
chauffer le matériau de dépôt (75) en fournissant plus de chaleur à la première région extérieure (204₁) qu'à la région centrale (204₃) via au moins un premier élément chauffant (230H) configuré comme un câble chauffant sensiblement parallèle à l'axe longitudinal de ladite source d'évaporation linéaire (100).

11. Procédé selon la revendication 10, dans lequel le chauffage du matériau de dépôt (75) comprend :
chauffer le matériau de dépôt (75) avec un premier élément chauffant (230H) disposé en dessous de la région intérieure (204), dans lequel
le premier élément chauffant (230H) est configuré pour fournir de la chaleur à un débit plus élevé à la première région extérieure (204₁) qu'à la région centrale (204₃) ; et
un débit de chaleur fourni par le premier élément chauffant (230H) à la première région extérieure (204₁) par rapport à un débit de chaleur fourni par le premier élément chauffant (230H) à la région centrale (204₃) est un premier rapport.

12. Procédé selon la revendication 10 ou 11, dans lequel le chauffage du matériau de dépôt (75) comprend :
chauffer le matériau de dépôt (75) avec un deuxième élément chauffant (250H) disposé au-dessus du matériau de dépôt (75), dans lequel
le second élément chauffant (250H) est configuré pour fournir de la chaleur à un débit plus élevé à la première région extérieure (204₁) qu'à la région centrale (204₃) ; et
un débit de chaleur fourni par le deuxième élément chauffant (250H) à la première région extérieure (2041) par rapport à un débit de chaleur fourni par le deuxième élément chauffant (250H) à la région centrale (204₃) est un deuxième rapport.

13. Procédé selon la revendication 12 utilisé pour la fabrication de films minces CIGS, dans lequel le deuxième rapport est différent du premier rapport.

14. Procédé selon la revendication 13, comprenant en outre
mesurer une première température dans la première région externe (204₁);
mesurer une seconde température dans la région centrale (204₃) ;
calculer une différence entre la première température et la seconde température ; et
ajuster un débit de chaleur fourni par le premier élément chauffant (230H) à la région intérieure (204) par rapport à un débit de chaleur fourni par le deuxième élément chauffant (250H) à la région intérieure (204) sur la base de la différence entre la première température et la deuxième température.

15. Procédé selon la revendication 12 ou 13 ou 14 utilisé pour la fabrication de couches minces CIGS, dans lequel le deuxième rapport est supérieur au premier rapport.

16. Procédé selon la revendication 15, comprenant en outre
mesurer une première température dans la première région externe (204₁);
mesurer une seconde température dans la région centrale (204₃), dans laquelle la seconde température est supérieure à la première température ;
calculer une différence entre la première température et la seconde température ; et
augmenter un débit de chaleur fourni par le deuxième élément chauffant (250H) à la région intérieure (204) par rapport à un débit de chaleur fourni par le premier élément chauffant (230H) à la région intérieure (204) sur la base de la différence entre la première température et la deuxième température.
